Europäisches Patentamt

(19) European Patent Office

Office européen des brevets

(11) Publication number: **0 137 209**
**A2**

(12) **EUROPEAN PATENT APPLICATION**

(21) Application number: **84109528.4**

(22) Date of filing: **10.08.84**

(51) Int. Cl.⁴: **C 30 B 15/00**
**C 30 B 29/06, C 30 B 15/04**

(30) Priority: **16.08.83 US 523555**

(43) Date of publication of application:
**17.04.85 Bulletin 85/16**

(84) Designated Contracting States:
**DE FR GB**

(71) Applicant: **International Business Machines Corporation**
**Old Orchard Road**
**Armonk, N.Y. 10504(US)**

(72) Inventor: **Ahlgren, David Cutler**
**Roethal Drive**
**Hopewell Junction New York 12533(US)**

(72) Inventor: **Deines, John Louis**
**Salt Point Turnpike**
**Pleasant Valley New York 12569(US)**

(72) Inventor: **Hearn, Eric White**
**36 Pye Lane**
**Wappingers Falls New York 12590(US)**

(72) Inventor: **Kulkarni, Murlidhar Vasudeo**
**R.R. 3, Box 173 William Street**
**Fishkill New York 12524(US)**

(72) Inventor: **Montillo, Francis Joseph**
**48 Tor Road**
**Wappingers Falls New York 12590(US)**

(72) Inventor: **Poponiak, Michael Robert**
**2 Stirrup Drive**
**Newburgh New York 12550(US)**

(72) Inventor: **Wang, James Jen-Ho**
**70 Dorset Street**
**Portland Maine 04102(US)**

(74) Representative: **Oechssler, Dietrich, Dr. rer. nat.**
**Schönaicher Strasse 220**
**D-7030 Böblingen(DE)**

(54) Silicon wafer and its application in producing integrated circuit devices.

(57) The semiconductor silicon wafer contains a small amount of oxygen and has a carbon concentration of greater than about 4 ppm.

Wafers of said kind are provided by slicing the tail part of a melt-grown silicon crystal into wafers and subsequently selecting from the produced wafers those having a carbon concentration of greater than 4 ppm. These wafers are applied for producing integrated circuit devices by means of essentially known manufacturing procedures. The formed integrated circuit devices have a low device-leakage current.

FIG.1

./...

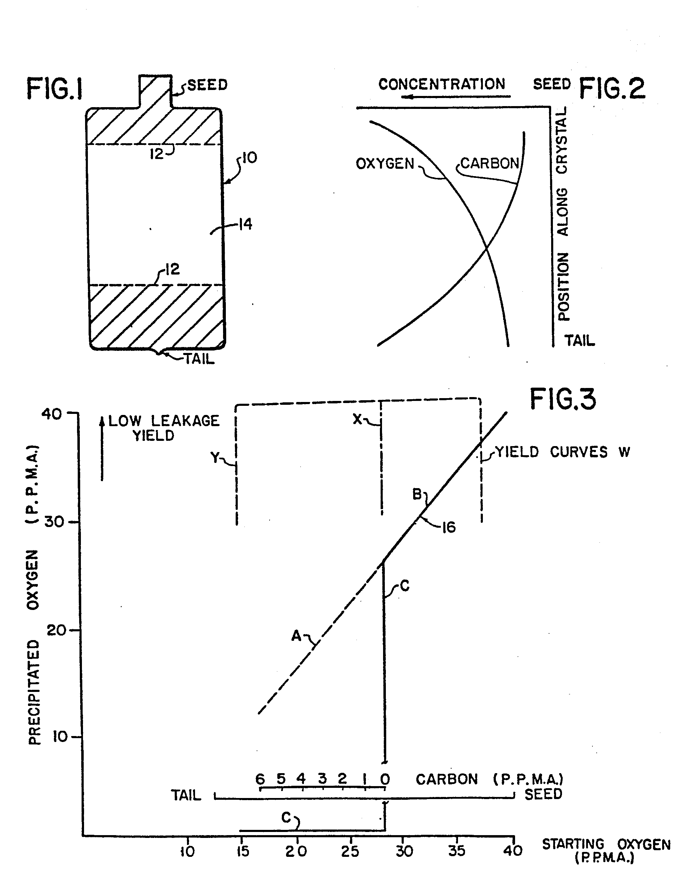

CONCENTRATION    SEED    FIG.2

OXYGEN    CARBON

POSITION ALONG CRYSTAL

TAIL

# SILICON WAFER AND ITS APPLICATION IN PRODUCING INTEGRATED CIRCUIT DEVICES

The invention relates to a semiconductor silicon wafer containing small amounts of carbon and oxygen and being suitable for fabricating a high quality and low device-leakage current integrated circuit device, and a method for producing integrated circuit devices following essentially known manufacturing procedures.

The following definitions and acronyms apply throughout the description:

Retention - the ability of a charged MOS device to retain a predetermined fraction of the initial charge.

Device-leakage current - loss of stored charge in a device ÷ period of loss.

Low level leakage yield - yield of devices at picoamp current levels.

Intrinsic defects - dislocations, stacking faults, point defects, grown-in impurities.

Extrinsic defects - surface impurities, process induced defects, dielectric definition, design related defects.

Oxygen concentration - concentration of oxygen that is found interstially in the silicon lattice.

FI 983 034

ppma - parts per million atoms, equivalent of $5 \times 10^{16}$ atoms/cm$^3$.

ASTM - American Society of Testing Materials. All concentrations of oxygen and carbon disclosed herein are on the basis of ASTM Standards F121-1979 and F123-1976, respectively.

In the fabrication of semiconductor wafers or substrates in which integrated circuits are to be embedded, it is often found, for example, in metal-oxide-semiconductor field effect transistor (MOSFET) device, that the device yield per wafer is limited by device-leakage current values. Since it is critically important, especially for application of these devices to dynamic memory cells, that a low value of device-leakage current or good charge retention be obtained, it has become necessary to reject or eliminate wafers that cannot meet the low device-leakage current requirements.

High device-leakage current is due to intrinsic crystallographic defects introduced in the wafer while growing the crystalline material (for example, dislocations) or extrinsic defects introduced during wafer shaping and device fabrication (for example, impurities, oxygen-induced stacking faults, etc.). The various types of defects can affect the integrated circuit performance differently depending on device design parameters and technology (FET or bipolar transistor).

In order that the present invention may be thoroughly understood and appreciated, some consideration of cer-

FI 983 034

tain important principles is believed to be useful. It has been known that so called gettering effect in the bulk of semiconductor bodies can be increased by heating the bodies prior to device processing in accordance with prescribed heat cycles. The heat is applied in order to generate oxygen precipitates and associated dislocation colonies which are utilized as gettering centers of unwanted impurities. For a thorough appreciation of a known method, reference may be made to U.S. Patent 4,220,483, assigned to IBM Corporation, the present assignee.

The fundamental objective of gettering is to generate gettering centers only in the bulk of the semiconductor wafer for removing mobile impurities from the top surface of the wafer and thereby obtain a high quality wafer material having a large defect-free zone at the surface thereof for the purpose of device fabrication. Without such gettering, there would be metallic impurity centers or sites that would militate against proper device operation.

Another source of background material relative to this invention is U.S. Patent 4,342,616 assigned to the present assignee. This patent discloses a measurement technique which makes for extremely efficient processing of semiconductor wafers because it enables the prediction of their propensity for oxygen precipitation and thereby, their characterization for ultimate device purposes, prior to the application of any heat treatment that is conventionally utilized.

Since the present invention relates to the presence of carbon in semiconductor wafers, reference may also be made to an article in the Journal of Vacuum Science

FI 983 034

Technology, Volume 14, No. 1, Jan/Feb 1977. In particular, there are statements on page 18 of that article relative to the incorporation of oxygen and carbon into silicon crystals, and certain concentration ranges are noted therein. These concentrations are referenced to silicon crystals, commonly grown in quartz crucibles, from melts which often contain oxygen in the range specified, i.e., 5-20 ppma and carbon in the range of 0.3-5 ppma. However, there is no indication of the presence of these particular ranges in wafers that have been cut from the crystals, which wafers are about to be processed in an integrated circuit production line where the criterion of low level leakage must be satisfied.

A further piece of background information that may prove of interest is the article by V. Sharma entitled "Semiconductor Silicon Substrate for High Yield", appearing in the IBM Technical Disclosure Bulletin, Vol. 18, No. 2, July 1975. As in the case of the article in Journal of Vacuum Science Technology commented on above, the concern here is with a crystal growing operation in which the substrate is provided with an oxygen concentration greater than 20 ppma and a carbon concentration of less than 4 ppma. Such a substrate is produced by growing a crystal, typically by using Czochralski or floating-zone growth techniques. However, the emphasis in this article is on obtaining the high oxygen concentration specified and low carbon concentration so as to improve the resistance of the crystal to slip and dislocation.

Yet other background information of interest is: articles in Semiconductor Silicon 1977, edited by H. R. Huff and R. R. Burgess (Electrochemical Society,

FI 983 034

Princeton, N.J.) by Graff et al, entitled "Process-Induced Defects in Oxygen and Carbon-Rich Silicon Crystals", particularly page 580 thereof and by K. V. Ravi and K. A. Pickar entitled "Defects in Silicon", particularly page 561 thereof. Both of these references point out the detrimental effects on devices due to the presence of carbon.

An additional article is "Precipitation of Oxygen and Carbon in CZ Silicon" by J. Wang and M. Kulkarni, appearing in Extended Abstracts, Vol. 80-2 of the Electrochemical Society, Fall Meeting at Hollywood, Florida, October 5-10, 1980, pages 1330-1332. This article teaches that above the oxygen concentration of 28 ppma in silicon, the rate of oxygen precipitation increases with the initial oxygen concentration and below 27 ppma the precipitation rate varies with the carbon concentration.

Reference is also made to the article by M. Ogino et al entitled "Two-Step Thermal Anneal and Its Application to a CCD Sensor and CMOS LSI" appearing in J. Electrochemical Soc., Vol. 130, No. 6, p. 1399, June 1983. This article discloses that in a two-step silicon anneal process consisting of a preheat treatment at 800°C to control microdefects and a high temperature anneal at 1050°C to grow microdefects, a reduction in interstitial oxygen takes place only when the initial oxygen exceeds a certain critical value. This critical value apparently decreases with increase in the first anneal time and substitutional carbon concentration.

It is the object of the invention to provide a unique semiconductor silicon wafer and the application of such a wafer for producing with high yield integrated circuit devices having low device-leakage currents.

This object is achieved by a semiconductor silicon wafer as defined at the beginning of this specification having the feature of the characterizing part of claim 1 and by a method as defined at the beginning of this specification having the features of the characterizing part of claim 8.

What has been discovered by the present inventors is that carbon plays a significant role in enhancing oxygen precipitation, or, perhaps better stated, in effecting such precipitation in a situation where it would not normally be expected to occur. The rate of this "effective" oxygen precipitation can be substantial - and in fact, can be equal to the "normal" rate of precipitation (i.e. high rate of oxygen precipitation) - despite the fact that the oxygen concentration would be regarded by one skilled in the art as insufficient to provide a useful wafer. By useful wafer is meant one that has large defect-free zones and improved quality crystal lattice in surface regions thereof for meeting low device-leakage current requirements imposed on FET devices, or similar requirements on related types of devices, such as bipolar devices.

A primary feature of the present invention, therefore, resides in a unique silicon wafer having a relatively high carbon concentration and an oxygen concentration that can be surprisingly low. Using such a wafer the required low device-leakage currents are achieved, thereby making the wafers suitable for fabricating thereon IC devices having such a device criterion. As a conclusion it can be said that in silicon providing

FI 983 034

a useful wafer material for producing various integrated bipolar and FET devices the upper limit of the carbon content - being defined to be 4 ppm in the article of V. Sharma mentioned above - can be extended beyond this value.

It is believed that the reason that carbon plays such a beneficial role is that it (1) does not generate defects in the surface region of the wafer and (2) does generate defects of the right kind such as carbon-oxygen dislocation complexes in the bulk of the wafer. Since the wafer contains a rather low concentration of oxygen, the defects in the surface region of the wafer due to oxygen are minimal. As a result of this synergistic effect of low oxygen concentration and high carbon concentration, large defect-free zones having a high quality crystal lattice are formed on the wafer surface. Wafers with such properties constitute the environment in which high quality integrated circuit devices are to be formed. One very important aspect of the invention is that the said wafers are made of a part of the crystal hitherto cropped off. Therefore the invention allows to increase remarkably the yield of device quality wafers from a melt-grown silicon crystal.

In a preferred embodiment the oxygen concentration in the wafer is relatively low, less than about 28 ppma and the carbon concentration in the wafer is in the range from preferably about 4 ppma to the solid solubility limit of carbon in silicon. For the device performance it is even advantageous if the oxygen content is below 20 ppm.

FI 983 034

The inventive wafers are advantageously applied in a process of manufacturing bipolar and FET integrated circuit devices.

The wafers used for the inventive method are preferably provided by the tail end of the silicon crystal which is normally rejected due to an oxygen concentration of below about 28 ppm. The wafers used are suitable for device fabrication because of the effective oxygen precipitation characteristic due to carbon concentration therein in the preferred range between about 4 ppma and the solid solubility limit of carbon in silicon. The inventive wafers upon being subjected to suitable processing conditions, such as VLSI bipolar or MOSFET processing, will have significantly improved device yield due to large defect-free zones with improved silicon lattice at the surface region and gettering sites in the bulk of the wafer material.

Advantageous embodiments of the inventive wafer and the inventive method are defined in the subclaims.

The invention will become more apparent from the following detailed description taken in conjunction with the accompanying drawings.

FIG. 1    is an illustration of a typical melt-grown semiconductor crystal.

FIG. 2    is a graph, correlated with FIG. 1, which depicts exemplary curves for oxygen and carbon concentrations in accordance with the invention.

FI 983 034

FIG. 3    is a graph which depicts (a) relationships between starting oxygen (abscissa) and precipitated oxygen (ordinate), taken along a typical crystal such as seen in FIG. 1 in both the case of the prior art and of the invention; FIG. 3 also depicts (b) the yields obtained in accordance with the prior art, and in accordance with the present technique for which low level leakage is the fundamental criterion.

Referring now to the figures of the drawing, and particularly to FIG. 1, there is seen depicted a typical large silicon crystal 10 grown from the melt in accordance with Czochralski or floating-zone growth techniques. One end of the crystal 10 is designated "seed" and the other "tail" for reasons apparent to those versed in the art.

In the Czochralski grown crystal, which is used for nearly 90 % of the silicon single-crystal requirements of the semiconductor industry, the crystal contains two unintentional impurities: oxygen and carbon. Oxygen results from a partial dissolution of the wall of the quartz crucible in which the crystal growth is achieved by melting a charge. Carbon exists in the Czochralski silicon because of the contributions from the original polycrystalline starting material and from the many graphite hot-zone components in the crystal-growing furnace.

After the crystal 10 has been formed by such techniques, the shaded areas depicted in FIG. 1 are usually cropped off. Thus, only the portion of the crystal 10 between the dotted lines, that is, portion 14 (known herein as

FI 983 034

the prime portion) between the lines 12 shown in this figure is retained for device fabrication. This is because the conventional practice has been based on having an appropriate oxygen content, either precipitated initially or precipitated continually during the thermal processing steps of device fabrication. Only those parts or portions of the crystal with high oxygen content, typically greater than 28 ppma but not greater than 36 ppma, are further processed by being cut into wafers, which are then placed on the production line. The reason for eliminating the shaded tail portion is that the general experience has been that wafers with less than 28 ppm. of oxygen have undesired variability in their retention times (inverse of leakage). The reason for eliminating the shaded seed portion is that device yields are adversely affected with oxygen levels greater than 36 ppm.

However, as already indicated, it has been discovered by the present inventors that the rate of oxygen precipitation depends upon the carbon content of the wafers; the precise effects of the carbon content and the concentrations thereof that may be judiciously employed to increase yield will be detailed hereinafter.

Referring now to FIG. 2, a typical set of curves depicting the concentrations of oxygen and carbon in the crystal 10 are shown. It will be understood that a whole variety of curves are possible and that the ones shown are merely exemplary for the purpose of explaining the invention. The carbon and oxygen concentrations of the wafers utilized in accordance with the invention are usually measured simultaneously. These measurements are made by infrared spectrometric methods well known

FI 983 034

in the art, such as Fourier transform infrared spectrometer (FTIR) technique.

Referring now to FIG. 3, there will be seen, first of
all, a graph depicting relationships between the starting oxygen in a typical crystal, such as crystal 10,
versus the precipitated oxygen. It will, of course, be
understood by one skilled in the art that a series of
heat cycles is carried out (e.g. 15 minutes at 780°C;
ramp up for 20 minutes to 925°C, stay at 925°C for
90 minutes; ramp down for 40 minutes to 780°C; stay
there for 15 minutes). The difference in oxygen readings before and after the heat cycles represents the
amount of oxygen precipitation.

Two different cases are depicted in FIG. 3, the solid
lines representing the normal case, and the dotted
lines the case of the present invention in which carbon
is present in significant concentrations. The normal
precipitation characteristic or rate, that is, the
rate when carbon is present at very low levels, (for
example, virtually zero) and with oxygen at relatively
high levels above 28 ppm., is as seen in the portion B
(solid line) of the curve 16. This corresponds with the
prime portion 14 of the crystal 10 (FIG. 1), that is,
the portion normally destined to be cut into wafers for
device fabrication on a production line. It should be
noted, however, that carbon could be present in the
prime or B portion.

The C portion of the curve 16 represents a substantially wasted portion of the crystal because with the
oxygen concentration less than 28 ppm. and with the
carbon concentration less than 0.5 ppm., devices resulting from the cut wafers of this C portion would

FI 983 034

normally not have desirably low levels of device-leakage current. Thus, there is seen the normally abrupt drop in the precipitated oxygen once the oxygen concentration drops below 28 ppm., followed by a constant low level at lower oxygen concentrations.

On the other hand, as seen by the dotted line portion A of the curve 16, the precipitation rate is transformed by the presence of carbon (at concentrations from about 0.5 ppm. to 6 ppm.), despite the low concentration of oxygen. Whatever the explanation for this result, the rate normally encountered with the B portion is now extended into the shaded tail part of the crystal 10 (FIG. 1) down to where the concentration of oxygen is about 15 ppm., which is virtually at the end of the crystal for the example given.

It will, therefore, be appreciated that a significant part of the crystal that has been wasted in conventional wafer processing can now be recovered for device purposes.

The yield curves W, X and Y, also shown on the graph of FIG. 3, illustrates the wide difference that can exist between the case of standard or conventional wafer usage and the case of the present invention where much more of the crystal becomes available and the yield is vastly improved. Yield curve W illustrates the drop-off of the device yield in wafers having an initial oxygen concentration of greater than about 38 ppma and no carbon concentration. Curve X represents the drop-off in device yield in the case of silicon wafers which have an initial concentration of greater than about 28 ppma and no carbon concentration at all. In other words, yield curves W and X represent the

FI 983 034

variation of the yield as a function of oxygen and carbon concentration in the silicon wafer in accordance with the conventional wisdom. Yield curve Y illustrates the improved yield in accordance with the present invention. This curve shows that the device yield in silicon wafers having an initial concentration of less than about 28 ppma and carbon concentration of greater than about 0.5 ppma. In other words, this invention demonstrates that yield drop-off will not occur per curve X but rather it occurs per curve Y.

In order to substantiate the results achievable with the present invention, and to assist the man skilled in the art to practice its principles, several studies conducted with a variety of groups of wafers having differing carbon contents are herewith set forth.

The intent of one study was to evaluate the low leakage yield of MOS capacitors on the wafers or substrates cut from a particular crystal, designated PN-328, as a function of oxygen and carbon concentrations. The basic result of this study is that the highest yields of low device-leakage current were directly correlated to substrates of relatively high carbon content. The wafers were oxidized to approximately 5000 angstrom in a suitable pyrogenic hydrogen-oxygen furnace at 1000°C. Aluminum dots, backside aluminum contact and a sixty minute 400°C forming gas sinter completed the MOS device processing.

The retention time ($R_T$) yield was measured on each wafer by using 40 aluminum dots, 60 mil in diameter (i.e. an area of 1.8 mm$^2$). Standard retention time measurements monitored the time in seconds to reach a five percent change in capacitance at deep depletion,

FI 983 034

using a 500 picoamp cutoff. Oxygen and carbon concentration had been previously measured by Fourier transform infrared spectrometer (FTIR).

The picoamp leakage yield is listed in Table I. The yield at less than 20 picoamps for the PN-328 crystal varies depending on the carbon concentration. The highest yield wafers correspond to the highest carbon content (with the oxygen concentration held constant). The effect of oxygen concentration on retention time yield was not readily apparent as the oxygen varied from 27 to 44 ppma.

The data presented in Table I shows a number of other beneficial effects due to the present carbon in the silicon wafers. First, the MOS devices fabricated by a conventional process of the VLSI type have an improved device-leakage current of 20 pA/1.8 mm$^2$ = 10 pA/mm$^2$ or better. Second, in the case of silicon wafers having an initial oxygen concentration in the medium value of about 31 ppma the yield of the above-mentioned improved MOS devices increased by about 200 % (from 23 % to 73 %) as the initial carbon concentration varied from a low value of about 1.09 ppma to a high value of about 3.24 ppma. A yield improvement of about 50 % is seen in wafers having a low oxygen concentration of about 27 ppma as the carbon concentration increased from 1.73 ppma to 2.92 ppma. Thus, presence of carbon in silicon not only results in an improved device-leakage current MOS devices but also improved yield of these devices as the carbon concentration increases.

The above improvement is realized without additional heat cycling of the wafers prior to retention time measurement. This indicates that a substantially

FI 983 034

improved quality of silicon material for device fabrication is realized without necessitating additional process steps for formation of defects, by further precipitation of oxygen, in the wafer bulk.

TABLE I

PN-328

EFFECT OF CARBON AND OXYGEN
CONCENTRATION ON $R_T$ YIELD

| % Yield for Leakage of | | | | | |
|---|---|---|---|---|---|
| < 500pA | <200pA | <60pA | <20pA | Oxygen Conc. | Carbon Conc. |
| 100 | 100 | 95 | 0 | High 44 ppma | Low 0.43 ppma |
| 100 | 95 | 85 | 23 | Med 31 ppma | Low 1.09 ppma |
| 100 | 93 | 83 | 48 | Low 27 ppma | Med 1.73 ppma |
| 100 | 100 | 95 | 73 | Low 23 ppma | High 2.92 ppma |
| 100 | 95 | 92 | 73 | Med 31 ppma | High 3.24 ppma |

A second study was conducted to determine the effects of oxygen and carbon on junction leakage limited yield of bipolar devices after interconnecting the transistors by means of the first level metal interconnection. The study was performed on six groups of 20 wafers each of a VLSI circuit design, which was run through the production line for forming bipolar transistor integrated circuits. The six groups contained silicon wafers having a number of oxygen and carbon concentration ranges as illustrated in Table II.

The six groups that were selected were based again on the hypothesis that carbon plays a role in enhancing oxygen precipitation.

FI 983 034

It should be noted, first of all, that this second study confirmed the rate of oxygen precipitation results already depicted in FIG. 3, in which there occurs a region C where no precipitation occurs; further, there is an A region, or "cusp" region, where carbon is present in the range 0.5 to 6 ppma and causes oxygen effectively to precipitate when it normally would not. The third region (B region) is where only normal precipitation effects occur.

As seen in the Table II below, a number of device evaluations are composed of screened experimental wafers. These experimental crystals had full seed to tail wafer traceability. All oxygen and carbon measurements were made on an FTIR. The testing procedure consisted of testing big emitter transistors for junction leakage at 190 sites on the wafer and preparing a histogram of devices having a junction leakage in the range of $1-10^9$ pA. Large emitter area transistors were utilized for increasing the probability of detecting defects. The results of the data that were run are summarized in Table II.

FI 983 034

TABLE II

| Experiment | Low Level Leakage % Picoamp Yield* | Final Transistor Test - % Yield | Chained Transis-tors % LLY |
|---|---|---|---|
| A | 79.3 | 87.8 | 43.5 |
| B | 69.1 | 87.8 | 34.2 |
| C | 55.4 | 81.0 | 24.2 |

* Percent of devices having emitter to collector
leakage $\leq$ 10 pA/0.7 mm$^2$

Both oxygen and carbon were measured, and the areas or regions selected for the study were defined as follows:

Experiment A = carbon greater than 0.5 ppma and oxygen less than 28 ppma.

Experiment B = carbon less than 0.5 ppma and oxygen greater than 28 ppma.

Experiment C = carbon less than 0.5 ppma and oxygen less than 28 ppma.

In Table II the second column labeled as "low level leakage percentage picoamp yield" refers to the collector to emitter leakage data for a big emitter transistor having an emitter area of 0.7 mm$^2$ under a 15 volt voltage reverse bias applied to the emitter ($BV_{CES}$ at 15 volts). The third column labeled as "final transistor test percentage yield" designates the percentage yield of big emitter transistors with $BV_{CES} > 15$ volts

FI 983 034

and $I_{CES}$ < 30 µA. The last column in Table II entitled "Chained Transistors Percentage LLY" designates the percentage of chips on the wafer each having a chain of 6612 transistors connected in parallel which are fully functional, i.e. $I_{CEX}$ < 30 µA, $BV_{CBO}$ in the range 4-30 volts and $BV_{EBO}$ in the range 2-7 volts.

The results of Table II indicate several interesting features of the present invention. In the case of bipolar devices formed on a wafer having an initial carbon concentration greater than 0.5 ppma and oxygen concentration less than 28 ppma, the percentage of devices having emitter to collector leakage of less than 10 pA is 79.3 %. In contrast, the percentage of tested bipolar devices formed on a silicon wafer having an initial carbon concentration of less than 0.5 ppma and oxygen concentration of greater than 28 ppma which had emitter to collector leakage of less than 10 pA is only 69.1 %. Another interesting result is that the relatively insensitive test (i.e. the junction breakdown voltage measurement test, column 3 in Table II) shows that Experiments A and B yield the same results and that these device yields are higher by approximately 8% than Experiment C. The more sensitive chained transistor yield test, however, shows that the improvement in device yield between Experiments A and B is greater than 20 % and that between Experiments A and C is over 50 %. Further, the chained transistor low level leakage yield results indicate a significant improvement in A>B>C.

What the several studies have demonstrated is that wafers containing carbon that are normally rejected because of low oxygen can be used for obtaining high yield of low leakage devices. Moreover, it will be

FI 983 034

apparent to those skilled in the art that the improved technique of the invention can be applied to large scale fabrication of integrated circuits. For example, crystals that are intended to yield wafers suitable for such a production line are melt-grown with carbon present at concentrations in the range of approximately 0.5 to 10 ppma in the melt. At least two groups of wafers are screened or sorted: a first group, typically derived from the tail end having an oxygen concentration less than about 28 ppma and extending down to about 16 ppma. The rising gradient of carbon concentration in the tail end means that the individual wafers in this group which are cut from the crystal will have the A region oxygen precipitation rate depicted in FIG. 3; hence, they will be suitable, along with the wafers of the second group cut from the B region, for use in the production line. The leakage limited yield of wafers thus obtained will be substantially improved over conventional practice which has been to reject wafers having oxygen concentrations below about 28 ppma.

The theoretical mechanism by which the above beneficial effects due to the presence of carbon in silicon is not fully understood, but it is believed that carbon when incorporated in suitable amounts plays a major role in producing a high quality crystal lattice in the surface region of the wafer when such a carbon incorporated silicon is thermally treated. The thermal treatment is, typically, that present in a conventional integrated circuit fabrication process of the type used in VLSI technologies. Under these processing conditions carbon enhances the size of defect free zones in the surface regions of the silicon substrate material. Carbon prevents generating defects in the surface region by enhancing gettering of impurities. Second, carbon generates defects of the right kind, namely, dislocation complexes, in the bulk of the silicon material. Added to these beneficial effects on the properties of the silicon material due to the presence of high amounts of carbon are the benefits due to the absence of high amounts of oxygen in the material. Since the defect density is directly proportional to the oxygen concentration in silicon, the lesser the oxygen concentration the fewer are the defects. In other words, a low oxygen concentration and high carbon concentration combine in a synergistic fashion and bring about large defect-free zones and improved crystal lattice in the silicon material without sacrificing the benefits of intrinsic gettering by precipitation related defects.

The width of the defect free zones in carbonincorporated silicon is a function of the carbon concentration, oxygen concentration and the processing conditions. In a silicon wafer having an initial oxygen concentration in the range from 15-28 ppma carbon concentration in the range from about 0.5 ppma to solid solubility limit of carbon at the melting point of silicon the defect free zone is typically in the range of 10-50 µm when the wafer is subjected to a standard process cycle - such as a VLSI fabrication process cycle disclosed in the article by W. E. Harding entitled "Semiconductor Manufacturing in IBM, 1957 to the Present: A Perspective", IBM Journal of Research and Development, Vol. 25, No. 5, p. 647, September 1981.

It can be appreciated that solid solubility limit of carbon in silicon is a function of the processing temperature, the impurities in silicon, etc. For example,

0137209

the solid solubility limit of carbon in silicon as the melting point of silicon is approximately 10 ppma.

In summary, silicon containing a low oxygen concentration in the range 28-15 ppma and high carbon concentration in the range 0.5 ppma to solid solubility limit of carbon in silicon is an extremely viable wafer material for various circuit technologies such as bipolar and FET. When such a silicon material is subjected to the sequence of processing temperatures required of these circuit technologies, due to intrinsic gettering, large defect-free zones are formed on the surface regions of the wafer. Thus, a careful design of the precipitation-gettering cycle in the beginning of the fabrication process is not necessary with this wafer material. As a result of the present discovery not only the wafer yield from grown silicon crystalline material but also the device yield from each wafer is significantly improved. Since the wafers are provided with large defect-free zones, the devices formed thereon are of superior quality.

While there has been shown and described what is considered at present to be the preferred embodiment of the present invention, it will be appreciated by those skilled in the art that modifications of such embodiment may be made. It is therefore desired that the invention not be limited to this embodiment, and it is intended to cover in the appended claims all such modifications as fall within the true spirit and scope of the invention.

FI 983 034

C L A I M S

1. Semiconductor silicon wafer containing small amounts of carbon and oxygen and being suitable for fabricating a high quality and low device-leakage current integrated circuit device, characterized by a carbon concentration of greater than about 4 ppm.

2. Silicon wafer according to claim 1, wherein the carbon concentration is in the range between about 4 and the solid solubility limit of carbon in silicon.

3. Silicon wafer according to claim 2, wherein the carbon concentration is in the range between about 4 and about 10 ppm.

4. Silicon wafer according to any one of claims 1 to 3, wherein the oxygen concentration is less than about 36 ppm.

5. Silicon wafer according to claim 4, wherein the oxygen concentration is less than about 28 ppm.

6. Silicon wafer according to claim 4 or 5, wherein the oxygen concentration is greater than about 15 ppm.

7. Silicon wafer according to any one of claims 1 to 6, wherein the oxygen concentration is in the range between about 15 and about 20 ppm.

8. Method for producing integrated circuit devices following essentially known manufacturing procedures characterized by slicing the tail part of a melt-grown silicon crystal into wafers, measuring the concentrations of carbon and optionally of oxygen in the wafers and applying wafers having the features of any one of claims 1 to 7 for forming the integrated circuit devices.

9. Application of the method according to claim 8 for forming integrated circuit bipolar devices.

10. Application of the method according to claim 8 for forming integrated circuit FET devices.

FI 983 034

FIG.1

SEED
12
10
14
12
TAIL

FIG.2

CONCENTRATION        SEED

OXYGEN        CARBON

POSITION ALONG CRYSTAL

TAIL

FIG.3

PRECIPITATED   OXYGEN   (P.P.M.A.)

40
LOW LEAKAGE
YIELD
X
Y
YIELD CURVES W
B
30
16
C
20
A
10

6 5 4 3 2 1 0   CARBON (P.P.M.A.)
TAIL                          SEED

C

10   15   20   25   30   35   40   STARTING OXYGEN
(P.P.M.A.)